(19) Europäisches Patentamt
European Patent Office
Office européen des brevets

(11) **EP 4 186 792 A1**

(12) **EUROPEAN PATENT APPLICATION**

(43) Date of publication:
**31.05.2023 Bulletin 2023/22**

(21) Application number: **22210154.5**

(22) Date of filing: **29.11.2022**

(51) International Patent Classification (IPC):
**B64C 25/42** (2006.01) **F16D 55/00** (2006.01)
**G01K 13/08** (2006.01) **G01K 11/26** (2006.01)
**F16D 66/00** (2006.01)

(52) Cooperative Patent Classification (CPC):
**G01K 11/265; B64C 25/42; B64D 45/00;**
**F16D 66/00; G01K 13/08;** B64D 2045/0085;
F16D 55/36; F16D 2066/001

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.11.2021 US 202163284284 P**

(71) Applicants:
• **Airbus Operations Limited**
**Bristol BS34 7PA (GB)**
• **Airbus Opérations SAS**
**31060 Toulouse (FR)**

(72) Inventors:
• **DA CUNHA, Mauricio Pereira**
**Orono, 04473 (US)**
• **LAD, Robert J.**
**Orono, 04473 (US)**
• **WHITE, Ian**
**Bristol BS34 7PA (GB)**
• **BRUGGEMANN, Kurt**
**Bristol BS34 7PA (GB)**
• **DOWNING, Richard**
**Bristol BS34 7PA (GB)**
• **CONSOLA, Maud**
**Bristol BS34 7PA (GB)**

(74) Representative: **EIP**
**Fairfax House**
**15 Fulwood Place**
**London WC1V 6HU (GB)**

(54) **TEMPERATURE SENSING DEVICE FOR AIRCRAFT WHEEL BRAKE**

(57) Disclosed is a temperature sensing device for sensing aircraft wheel brake temperature, the temperature sensing device comprising: a surface acoustic wave, SAW, sensor element comprising an interdigital transducer, the interdigital transducer comprising electrodes disposed along the surface of a substrate forming a periodic structure, the electrodes having a thickness, in a direction perpendicular to the surface, of between 120 and 190 nanometres. Also disclose is a brake disc comprising the temperature sensing device, an aircraft comprising the brake disc, and a method of manufacturing a temperature sensing device.

EP 4 186 792 A1

Figure 3

**Description**

TECHNICAL FIELD

The present invention relates to sensing aircraft wheel brake temperature.

BACKGROUND

When aircraft wheel brakes are deployed to reduce the speed of an aircraft, the temperature of the aircraft wheel brakes rises. It can be advantageous to monitor the temperature of the aircraft wheel brakes, for example, to ensure that the brakes do not overheat. For example, temperature sensors such as thermocouples can be used to sense temperature.

SUMMARY

A first aspect of the present invention provides a temperature sensing device for sensing aircraft wheel brake temperature, the temperature sensing device comprising: a surface acoustic wave, SAW, sensor element comprising an interdigital transducer, the interdigital transducer comprising electrodes disposed along the surface of a substrate forming a periodic structure, the electrodes having a thickness, in a direction perpendicular to the surface, of between 120 and 190 nanometres.

Optionally, the electrode thickness is substantially 180 nanometres.

Optionally, the SAW sensor element has a resonant frequency of 188 megahertz at a temperature of 24°C.

Optionally, the SAW sensor element comprises an input interdigital transducer and an output interdigital transducer; and the electrode thickness of both the input interdigital electrode and the output interdigital electrode is substantially the same.

According to a second aspect of the present invention, there is provided a brake disc for an aircraft wheel brake comprising the temperature sensing device according to the first aspect attached to the brake disc.

According to a third aspect of the present invention, there is a provided an aircraft comprising the brake disc according to the second aspect.

According to a fourth aspect of the present invention, there is provided a method of manufacturing a temperature sensing device for sensing aircraft wheel brake temperature, the method comprising: producing a surface acoustic wave, SAW, sensor element comprising an interdigital transducer, the interdigital transducer comprising electrodes disposed along the surface of a substrate forming a periodic structure, the electrodes having a thickness, in a direction perpendicular to the surface, of between 120 and 190 nanometres; and providing the temperature sensing device comprising the SAW sensor element.

Optionally, in the method according to the fourth aspect, the electrode thickness is 180 nanometres.

BRIEF DESCRIPTION OF THE DRAWINGS

Embodiments of the invention will now be described, by way of example only, with reference to the accompanying drawings, in which:

Figure 1 is a simplified schematic view of an aircraft on which examples may be deployed;

Figure 2 is a simplified schematic view of a brake and a wheel of an aircraft landing gear assembly according to an example;

Figure 3 is a simplified schematic block diagram of a temperature sensing device according to a first example;

Figure 4 is a simplified schematic plan view of a surface acoustic wave sensor element, according to an example;

Figure 5 is a simplified schematic block diagram of a temperature sensing system according to an example;

Figures 6a is a simplified schematic side cross-sectional view of a surface acoustic wave sensor element, according to a first example;

Figures 6b is a simplified schematic side cross-sectional view of a surface acoustic wave sensor element, according to a second example;

Figures 7a is a graph showing example data in relation to a surface acoustic wave sensor element according to the first example;

Figures 7b is a graph showing example data in relation to a surface acoustic wave sensor element according to the second example;

Figure 8 is a flow diagram of a method of manufacturing a temperature sensing device, according to an example; and

Figures 9a to 9d are simplified schematic side cross-sectional views of a surface acoustic wave sensor element at different stages of production, according to an example;

DETAILED DESCRIPTION

The following disclosure relates to a temperature sensing device for sensing aircraft wheel brake temperature.

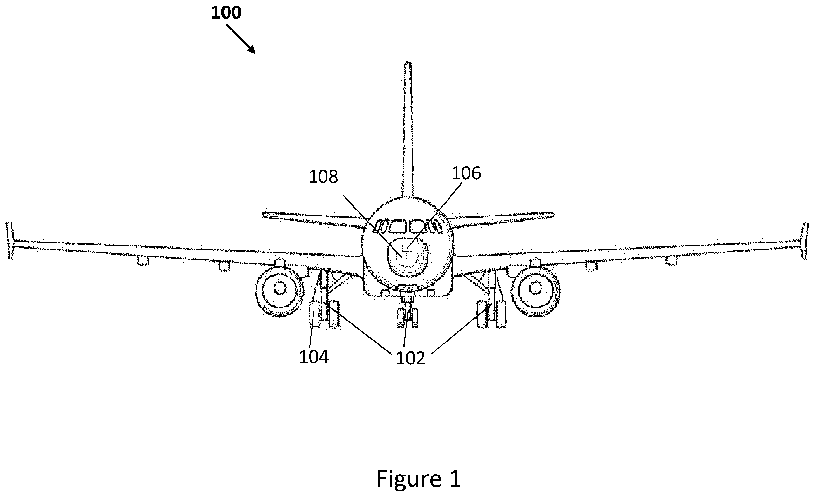

Figure 1 is a simplified schematic view of an aircraft 100. The aircraft 100 comprises a plurality of landing gear assemblies 102. The landing gear assemblies may include main and nose landing gears that are deployed or extended during take-off and landing. Each landing gear assembly 102 includes wheels 104. The aircraft 100 comprises a computing system 106, which, for example, comprises one or more processors and one or more computer readable storage media. The aircraft 100 may also comprise instruments 108, such as instruments or sensors for measuring characteristics or parameters related to the aircraft, and instruments or sensors for measuring environmental characteristics.

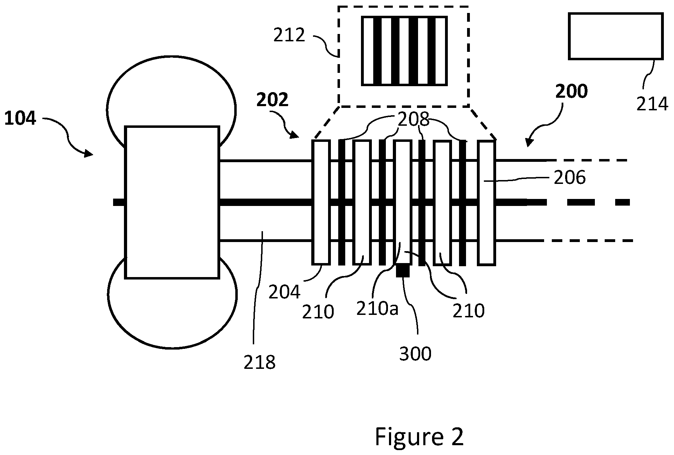

Figure 2 is a simplified schematic view of an aircraft wheel brake 200 associated with the wheel 104 of the aircraft 100. The wheel brake 200 applies a braking force to inhibit the rotation of the wheel 104 when applied. Each of the wheels of the aircraft 100 may have a wheel brake 200 associated with it. In this example, the wheel brake 200 comprises a plurality of brake discs 202 including a pressure plate 204, a reaction plate 206, and a number of rotors 208 and stators 210. In this example, the brake discs 202 include a plurality of rotors and stators, and the wheel brake 200 is therefore a multiple disc brake. In other examples, the wheel brake 200 may not be a multiple-disc brake: there may be only one disc 208, for example, between a pressure plate 204 and a reaction plate 206. In some examples, the brake discs 202 may include up to 9 discs or 11 discs, or any other number which is suitable for a wheel brake of an aircraft. The brake discs 202 may collectively be referred to as a heat pack. The components of the wheel brake 200 (hereafter, for brevity, the wheel brake 200 is referred to simply as the brake 200) such as the brake discs 202 may be housed in a wheel brake housing (not shown). As referred to herein, the term brake is used as if to include such a wheel brake housing.

It will be understood that the type of wheel brake used in an aircraft landing gear depends on the characteristics of the aircraft in question, such as size, carrying capacity and the like. The following may be applied to any wheel brakes suitable for use as aircraft wheel brakes which heat up when applied to reduce aircraft speed, as discussed in the following.

When the aircraft 100 travels along the ground supported by the landing gear assembly 102, the rotors rotate with the wheel 104 (the rotors are keyed to the wheel 104), whereas the stators, the pressure plate 204 and the reaction plate 206 do not rotate with the wheel 104 (the stators, the pressure plate 204 and the reaction plate 206 are keyed to a torque tube 218 associated with the wheel 104 which does not rotate with the wheel 104). When braking is applied, the pressure plate 204 is urged towards the reaction plate 206 so that the brake discs 202 come into contact with one another (as shown in box 212 of Figure 2) and friction acts to inhibit the rotational motion of the rotors, thus generating a braking force. When the brake 200 is applied, some of the kinetic energy of the aircraft 100 is absorbed into the brake discs 202 as heat (by the action of friction). Accordingly, the brake 200 heats up when it is applied to cause the aircraft 100 to slow down.

Any one or more of the rotors, stators, pressure plate 204 and the reaction plate 206 may be composed of Carbon-Carbon (CC) composites. A brake including brake discs composed of CC composites may be referred to as a carbon brake. For example, the brake discs 202 may be composed of a graphite matrix reinforced by carbon fibers.

In this example, the aircraft 100 comprises a braking system 214 which controls the operation of the brake 200. The braking system 214 causes the brake 200 to be applied in response to a braking request (e.g. when a pilot of the aircraft 100 presses a brake pedal). For example, the brake 200 may be hydraulically actuated in which case the braking system 214 includes a hydraulic system (not shown) operationally connected with the brake 200. In other examples, the brake 200 may be electrically actuated in which case the braking system 214 includes an electronic brake actuation system. The braking system 214 may be controlled by the computing system 106.

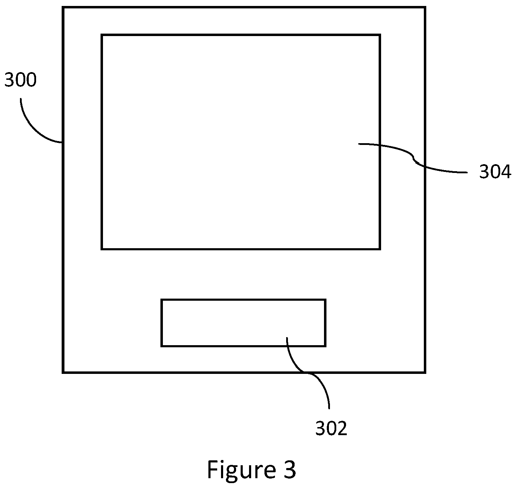

Figure 3 is a simplified schematic view of a temperature sensing device 300. The temperature sensing device 300 is for sensing aircraft wheel brake temperature (for example, the temperature of the brake 200). For example, the temperature sensing device 300 may be attached to a component of the brake in order to sense the temperature of that component of the brake 200. For example, the temperature sensing device 300 may be attached to one of the brake discs 202. In the example of Figure 2, the temperature sensing device 300 is attached to one of the stators. For example, the temperature sensing device 300 is attached to a first stator 210a, as schematically shown.

The temperature sensing device 300 may be attached to the first stator 210a in a manner that can withstand the high temperatures expected to occur at the first stator 210a. For example, the temperature sensing device 300 may be attached to the first stator 210a by means of a ceramic adhesive. Ceramic adhesive may be intended to withstand high temperatures, for example in excess of 1000°C. For example, the ceramic adhesive may be applied between the first stator 210a and the temperature sensing device 300 and cured such that the temperature sensing device 300 is bonded to the first stator 210a using cured ceramic adhesive material (for example, ceramic epoxy adhesive material). In some examples, the first stator 210a comprises a first formation (for example, one or more grooves). The first formation may be formed by cutting, grinding, drilling, or boring the first formation into the material of the first stator 210a. In such examples, a second formation may be formed from the ceramic adhesive to interlock with the first formation. For example, the ceramic adhesive with the second formation may be an attachment element for attaching the temperature sensing device 300 to the first stator 210a. For example, the second formation is complementary to the first formation. For example, the first formation is a groove formed in the first stator 210a and the second formation is a spike which fits into the groove to inhibit movement between the first stator 210a the attachment element along an axial direction and a circumferential direction of the first stator 210a. In some examples, providing the attachment element as described comprises applying uncured ceramic adhesive material to the surface of the first formation to create the second formation.

It will be appreciated that the temperature sensing device 300 may be attached to a brake disc in a number of ways. Alternatively, or in addition to the use of ceramic adhesive, other fasteners such as ceramic bolts may be used to attach the temperature sensing device 300. For example, a ceramic bolt may be passed through a through hole in the temperature sensing device 300 and engage with a threaded hole in the first stator 210a. In some examples, an appropriately shaped clip (for example, a metal clip) may be used as an attachment element. For example, the clip may comprise through holes and may be attached to the first stator 210a using bolts. Those skilled in the art will appreciate the various ways of attaching components to withstand high temperatures.

The temperature sensing device 300 comprises a surface acoustic wave (SAW) sensor element 302. In the example of Figure 3, the temperature sensing device also comprises a sensor antenna 304, which is electrically coupled to the SAW sensor element 302. The temperature sensing device 300 may be a passive device in that it does not require electrical power to operate. It will be understood that the SAW sensor element 302 works based on SAWs generated in the SAW sensor element 302. For example, the SAW sensor element 302 comprises a transducer which converts an input signal (for example, an electrical signal) into a surface acoustic wave that resonates in the SAW sensor element 302. The SAW sensor element 302 also, for example, comprises a transducer to convert the SAW into an output signal (for example, an output signal).

The temperature sensing device 300 may be configured to withstand the harsh environment of the brake discs 202. For example, the temperature sensing device may be configured to withstand at least one of: a saw tooth shock profile of 6g at 20ms duration, a saw tooth shock profile of 55g at 30ms duration, a saw tooth shock profile of 70g at 0.4ms duration, a half-sine shock profile of 40g at 30ms duration, a half-sine shock profile of 50g at 0.5ms duration, and vibration of 50g at 2 kHz for a minimum duration of 3 hours. Vibrations and/ or shock testing may be performed in accordance with Radio Technical Commission for Aeronautics (RTCA) DO-160G.

It will be understood that the SAW sensor element 302 works based on SAWs generated in the SAW sensor element 302. For example, the SAW sensor element 302 comprises a transducer which converts an input signal (for example, an electrical signal) into a surface acoustic wave that resonates in the SAW sensor element 302. The SAW sensor element 302 also, for example, comprises a transducer to convert the SAW into an output signal (for example, an output signal). Physical properties (such as temperature, for example) of the SAW sensor element may be determined based on the output signal.

The input signal may be referred to as an interrogation signal. That is because the interrogation signal causes the output signal based on which, for example, temperature can be determined. The interrogation signal therefore acts to query the SAW sensor element 302 to provide an output signal. The interrogation signal may be wirelessly received by the temperature sensing device 300. The output signal may be wirelessly transmitted by the temperature sensing device 300.

The SAW sensor element 302 comprises one or more interdigital transducers (IDTs). The IDTs are for converting between a SAW and, for example, an electrical signal. The functioning of an IDT is described further below. In some examples, the SAW sensor element 302 is a one-port SAW sensor. In such examples, the SAW sensor element 302 has one IDT. For example, the SAW sensor element 302 may have one IDT and reflectors either side of the IDT to reflect the SAW. In such examples, the one IDT converts an input signal into a SAW and also converts the SAW back into an electrical signal as a response (output) signal.

In some examples, the SAW sensor element 302 is a two-port SAW sensor. In such examples, the SAW sensor element 302 comprises two IDTs spaced apart from one another. There is an input IDT which converts an input signal into a SAW. The SAW travels from the input IDT to an output IDT. The output IDT converts the SAW into an output signal. Those skilled in the art will appreciate the various configurations of a SAW sensor element.

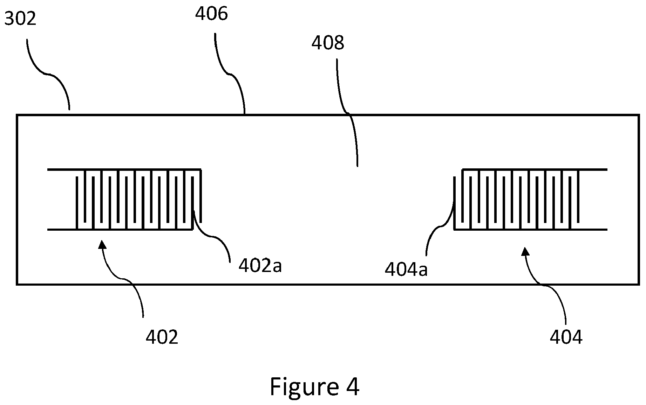

Figure 4 illustrates a particular example of the SAW sensor element 302. In this example, the SAW sensor element 302 is a two-port SAW sensor, and comprises an input IDT 402 and an output IDT 404. Each of the input IDT 420 and the output IDT 404 comprises two interlocking comb-shaped arrays of electrodes, deposited on the surface of a piezoelectric substrate 406 to form a periodic structure. The electrodes may be metallic electrodes, for example. In this example, the input IDT 402 comprises a first periodic electrode structure 402a and the output IDT 404 comprises a second periodic electrode structure 404a. The input IDT 402 is provided at a first location of the piezoelectric substrate 406 and the output IDT 404 is provided at a second location of the piezoelectric substrate 406 such that there is a space between the input IDT 402 and the output IDT 404.

Those skilled in the art will appreciate that a piezoelectric material can generate an electric charge in response to mechanical stress. Furthermore, a piezoelectric material can deform and generate mechanical stress in response to an applied electric field. An alternating electrical signal can be applied to the input IDT 402 such that adjacent electrodes have opposite polarities and the polarity of each electrode alternates according to the applied alternating electrical signal. Such a signal causes there to be a region of compressive stress next to a region of tensile stress, and each region alternates between compressive and tensile stress. As a result of this alternating compressive and tensile stress, there is generated a mechanical wave. This mechanical wave is what is referred to as a surface acoustic wave (SAW), as described above. SAWs in the SAW sensor element 302 are generated at the resonant frequency of the SAW sensor element 302.

In the example of Figure 4, the SAW travels from the input IDT 402 to the output IDT 404. The alternating regions of compressive and tensile stress caused by the SAW at the output IDT cause there to be alternating electric fields. These alternating electric fields generate an electrical signal in the output IDT such that the polarities of adjacent electrodes of the output IDT 404 alternate in the manner described above for the input IDT 402. In other words, an electrical signal is generated at the output IDT 404 by the reverse of the process which took place at the input IDT 402 to generate the SAW from the input electrical signal.

As previously described, the physical properties (such as temperature, for example) of the SAW sensor element may be determined based on the output signal. The characteristics of the SAW in the SAW sensor element 302 depend on the physical properties of the SAW sensor element such as temperature. Therefore, by detecting the characteristics of the SAW, the temperature of the SAW sensor element 302 can be determined. For example, the characteristics of the SAW are detected using the output signal generated by the output IDT 404 in response to an interrogation signal received at the input IDT 402.

Various characteristics of the SAW may be detected. For example, a delay relating to the transmission of the interrogation signal and receipt of the output signal in response from the temperature sensing device 300, a phase shift response of the SAW sensor element 302, and/or a resonant frequency of the SAW sensor element 302 may be detected. For example, the frequency of the output signal corresponds to the frequency of the SAW and therefore the resonant frequency of the SAW sensor element 302. A desired physical property of the SAW sensor element 302 (such as temperature) may then be determined from the detected characteristic of the SAW sensor element 302.

A predefined relationship between the detected characteristic (for example, the resonant frequency) of the SAW sensor element 302 and the temperature of the SAW sensor element 302 may be stored in a computer readable memory (for example, in the computing system 106) on the aircraft 100, for example. The predefined relationship specifies what the detected characteristic of the SAW sensor element 302 is expected to be at various different temperatures (for example, obtained from calibration and/or testing of the SAW sensor element 302). For example, from a given resonant frequency, the temperature of the SAW sensor element 302 is determined from the predefined relationship. The predefined relationship may be stored in the form of a look-up table, rule, correlation equation, graph, etc.

The predefined relationship may be determined by performing calibration or other test on the SAW sensor element 302. For example, test may be performed to cause the SAW sensor element 302 to resonate at different temperatures and determine the resonant frequencies at those temperature in order to establish the predefined relationship.

As previously described, the temperature sensing device 300 is attached to one of the brake discs 202. In the example of Figure 2, the temperature sensing device is attached to one of the stators 210. Therefore, the temperature of the SAW sensor element 302 corresponds to the temperature of the brake disc to which it is attached.

The interrogation signal may be wirelessly received by the temperature sensing device 300. The temperature sensing device 300 may comprise (as in the example of Figure 3) a sensor antenna 304 configured to wirelessly receive the interrogation signal, and supply the interrogation signal to the SAW sensor element 302. For example, the sensor antenna 304 receives the interrogation signal in the form of radio waves and converts the radio waves into an electrical signal. The SAW sensor element may be configured to, responsive to the interrogation signal, output a signal as a response (the described output signal), the output signal indicative of the resonant frequency of the SAW sensor element 302, to the sensor antenna 304. For example, the sensor antenna 304 may be configured to wirelessly transmit the output signal. For example, the sensor antenna 304 converts the electrical output signal into radio waves.

For example, the sensor antenna 304 supplies the interrogation signal to the input IDT 402 of the SAW sensor element 302. The interrogation signal as received at the input IDT 402 is an alternating electrical signal which causes the input IDT 402 to generate a SAW as previously described. The SAW sensor element 302 provides an output signal (generated by the output IDT 404 as previously described). For example, the output signal is supplied from the output IDT 404 to the sensor antenna 304. The sensor antenna 304 transmits the output signal. For example, the sensor antenna 304 is electrically coupled to the input IDT 402 and the output IDT 404. The origin of the interrogation signal and the components which receive and process the output signal are described later.

A change in temperature of the SAW sensor element 302 causes a change in the resonant frequency. For example, as the temperature of the SAW sensor element 302 increases, the resonant frequency of the SAW sensor element decreases. The frequency of the SAW depends on the spacing between the electrodes of the IDTs. The spacing between adjacent electrodes is referred to as the pitch of the IDT in question. The pitch determines the wavelength of the SAW generated by the IDT. The pitch is equal to half of the wavelength of the SAW generated by the IDT. Therefore, the desired frequency resonant frequency of the SAW sensor element

The frequency of the SAW depends on the propagation velocity of the SAW and the wavelength of the SAW according to Equation (1) below.

$$f = \frac{V_s}{\lambda} \tag{1}$$

In Equation (1), $f$ represents the frequency of the SAW, $V_s$ represents the propagation velocity of the SAW in the SAW sensor element in question, and $\lambda$ represents the wavelength of the SAW.

The frequency of the SAWs generated in the SAW sensor element 302 can be referred to as the resonant frequency of the SAW sensor element. It will be appreciated that, for a given propagation velocity of the SAW in the SAW sensor element 302, the resonant frequency of the SAW sensor element 302 can be configured by selecting an appropriate pitch for the IDTs of the SAW sensor element 302.

The temperature of the SAW sensor element 302 may be determined by detecting the resonant frequency of the SAW sensor element 302 as indicated by the output signal.

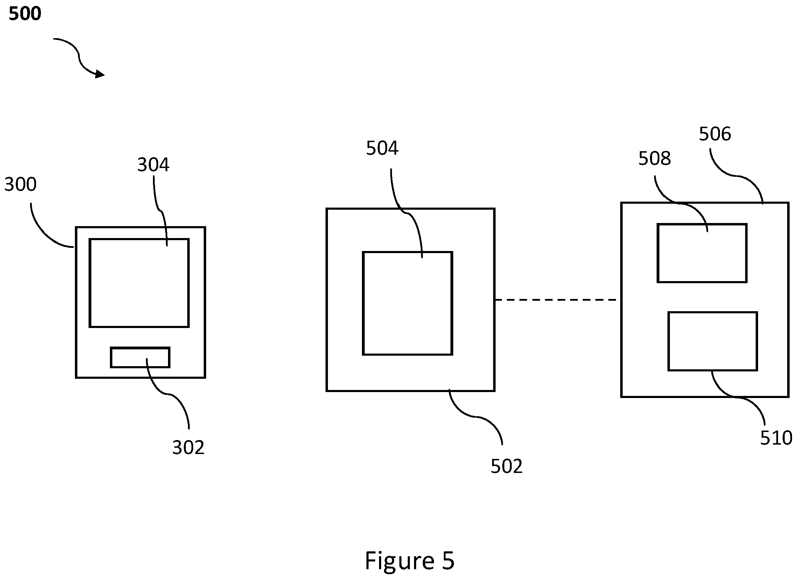

Figure 5 schematically illustrates an example of a temperature sensing system 500 for sensing aircraft wheel brake temperature. The temperature sensing system 500 comprises the temperature sensing device 300 according to any of the described examples. The temperature sensing system 500 also comprises a wireless relay device 502 for delivering the interrogation signal for wirelessly interrogating the SAW sensor element 302. The wireless relay device 502 delivers the interrogation signal by wirelessly transmitting the interrogation signal to the temperature sensing device 300. The wireless relay device 502 also wirelessly receives the described output signal. The wireless relay device 502 is hereafter simply referred to as the relay 502.

In some examples, the relay 502 comprises a relay antenna 504. The relay antenna wirelessly transmits the interrogation signal and wirelessly receives the output signal. In some such examples, the relay 502 is simply a device for communicating wirelessly with the temperature sensing device 300. As described, the temperature sensing device 300 may be attached to one of the brake discs 202. The relay 502 may be attached to a component of the brake 200 or wheel 104 such that it can wirelessly communicate with the temperature sensing device 300 attached to a brake disc. For example, the relay 502 may be mounted so as to maintain line of sight with the temperature sensing device 300.

The wireless communication between the temperature sensing device 300 and the relay 502 can be implemented, for example, by electromagnetic, inductive or capacitive coupling of the relay 502 to the temperature sensing device 300. For example, each of the sensor antenna 304 and the relay antenna 504 may be configured to convert electrical signals to radio waves and vice versa, with the radio waves being transmitted between the respective antennas.

In some examples, the temperature sensing device 300 is attached to the first stator 210a and the relay 502 is attached to the torque tube 218 to which the first stator 210a is keyed. In such examples, the relay 502 is attached to the torque tube at a position so as to be in the line of sight of the temperature sensing device 300 on the first stator 210a. In other examples, the temperature sensing device 300 may be mounted on a different brake disc or a different component of the brake 200, and the relay 502 may be mounted at an appropriate location to maintain line of sight with the temperature sensing device 300.

The temperature sensing system 500 may comprise an interrogation apparatus 506. The interrogation apparatus 506 may form part of the computing system 106 of the aircraft 100. In such examples, the interrogation apparatus 506 forms a communication link (which may be wireless or wired) with the relay 502. The interrogation apparatus 506 comprises a controller 508 configured to provide the interrogation signal. For example, the controller 508 may provide the interrogation signal based on a command signal received from another component of the computing system 106. The command signal may comprise the interrogation signal, and the interrogation signal may simply be retransmitted towards to the relay 502. In other examples, the command signal may be an instruction for the controller 508 to generate the interrogation signal.

In the example of Figure 5, the interrogation apparatus 506 comprises a transceiver 510 for transmitting the interrogation signal to the relay 502 and receiving the described output signal from the relay 502. The transceiver 510 may communicate with the relay 502 via a wired communication link or wirelessly. For example, for wireless communication, respective antennas may be provided as part of the relay 502 and the interrogation apparatus 506.

The SAW sensor element 302 has a resonant frequency within a frequency range between 175 megahertz (MHz) and 190MHz at a predetermined temperature. A frequency range between 175MHz and 190MHz is not limited to a range having 175MHz as a lower limit and 190MHz as an upper limit. For example, the frequency range may be any range that falls between 175 MHz and 190 MHz (for example, 175 MHz to 180 MHz, 176 MHz to 188 MHz, 180 MHz to 190 MHz, etc.). In some examples, the resonant frequency of the SAW sensor element 302 is within the frequency range when the temperature of the SAW sensor element 302 is within a predetermined temperature range (for example, 24°C to 1000°C).

The SAW sensor element 302 may comprise an IDT with an electrode thickness between 120 and 190 nanometres (nm). The IDT comprises electrodes disposed along the surface of a substrate forming a periodic structure. The thickness of the electrodes is in a direction perpendicular to the surface.

Referring to the example of Figure 4, the substrate is the piezoelectric substrate 406. The surface 408 of the piezoelectric substrate 406 between the electrodes is on a plane parallel to the page in Figure 4. The direction perpendicular to the surface 408 of the piezoelectric substrate 406 between the electrodes of the IDT (e.g., the input IDT 402) is into the page (i.e., perpendicular to the page) with respect to the orientation shown in Figure 4. The following description is in the context of the SAW sensor element 302 being a two-port SAW sensor according to the example of Figure 4.

The electrode thickness of the IDTs being between 120nm and 190nm advantageously provides for a SAW sensor element 302 which is adequately thin such that the size of the temperature sensing device 300 comprising the SAW sensor element 302 is appropriate for attachment to a brake disc such as the first stator 210a. The size of the temperature sensing device 300 being appropriate means that the temperature sensing device 300 is small enough (for example, thin enough) to be attached to a brake disc without requiring alteration of the functioning or any significant alteration of overall physical dimensions of the brake disc within the brake 200.

Characteristics of the input IDT 402 and the output IDT 404 may affect the operation of the sensor antenna 304. One parameter related to the sensor antenna 304 that may be affected by the characteristics of the IDTs is the reflection coefficient, S11. Those skilled in the art will appreciate that reflection coefficient, S11 is also known as the return loss, and represents how much power is reflected from the sensor antenna 304. For example, if S11 = 0 decibels (dB), then all the supplied power is reflected, and none of the power is delivered to or radiated by the antenna. If some of the supplied power is delivered to or radiated by the antenna, the S11 has a negative value. The lower the value (i.e., the larger the negative value in dB) of S11, the more of the power supplied to the antenna is accepted by or radiated by the antenna.

The electrode thickness of the IDTs between 120nm and 190nm provides the following advantages. The electrode thickness in this range provides for an adequate reflection coefficient S11 of the sensor antenna 304. The reflection coefficient S11 of the sensor antenna 304 is adequate when the temperature sensing device 300 can receive enough of the power of the interrogation signal to generate a SAW in the SAW sensor element 302. Also, the reflection coefficient S11 of the sensor antenna 304 is adequate when the output signal responsive to the interrogation signal can be transmitted with adequate strength for receipt by the relay antenna 504. An adequate reflection coefficient S11 for proper functioning is provided while the electrode thickness allows for the size of the temperature sensing device 300, comprising the SAW sensor element 302, to be appropriate for attachment to a brake disc such as the first stator 210a.

In some examples, the electrode thicknesses of the input IDT 402 and the output IDT 404 are substantially the same. In some examples, the electrode thickness is 180nm. For example, in the case of the electrode thicknesses of the input IDT 402 and the output IDT 404 being substantially the same, the electrode thickness of both the input IDT 402 and the output IDT 404 is 180nm.

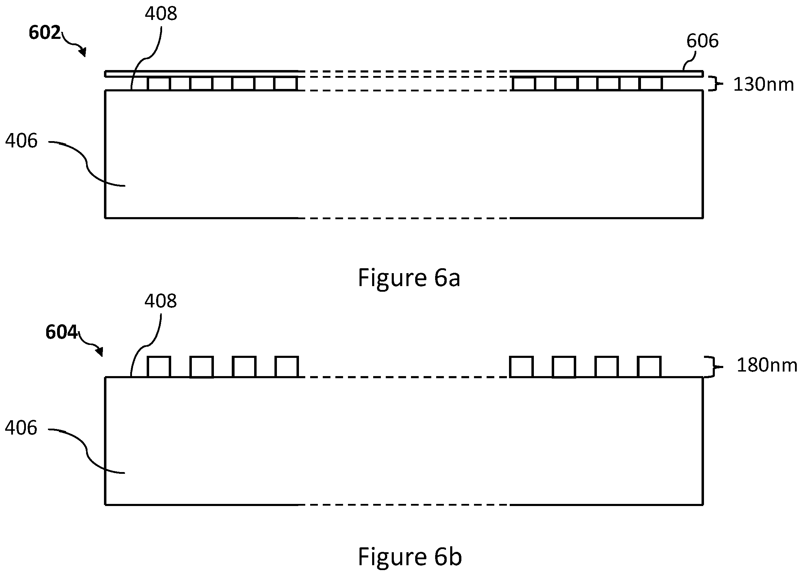

Figure 6a is a simplified schematic side cross-sectional view of a first example 602 of the SAW sensor element 302. In Figure 6a, a few electrodes of the input IDT 402 and the output IDT 404 of the first example 602 of the SAW sensor element that may be present are shown. The dashed lines in the centre of the first example 602 shown in Figure 6a indicate that parts of the first example 602 are not shown. Figure 6b is a simplified schematic side cross-sectional view of a second example 604 of the SAW sensor element 302. As with Figure 6a, in Figure 6b, a few electrodes of the input IDT 402 and the output IDT 404 of the second example 604 that may be present are shown. The dashed lines in the centre of the second example 604 shown in Figure 6b indicate that parts of the first example 602 are not shown. The first example 602 of the SAW sensor element comprises IDTs with an electrode thickness of 130nm. The first example 602 also comprises a cap layer 606. The cap layer comprises $Al_2O_3$. In this example, the cap layer 606 is 50nm thick. In Figure 6a, the cap layer 606 is schematically shown as a thin flat layer on top of the electrodes for simplicity. However, the cap layer 606 may encase the electrodes and/or contact the piezoelectric substrate 406. For example, the material of the cap layer 606 may contact the portions of the surface 408 of the piezoelectric substrate 406 not covered by the material of the electrode or other components.

The second example 604 of the SAW sensor element comprises IDTs with an electrode thickness of 180nm. The second example 604 of the SAW sensor element does not comprise a cap layer. It should be noted that Figures 6a and 6b are schematic and are not intended to indicate relative sizes of different components, specific numbers of electrodes to be provided, etc. Reference is made to the first/second example of the SAW sensor element with a particular electrode thickness. It will be appreciated that electrode thickness being referred to is that of the IDTs in the example of the SAW sensor element in question.

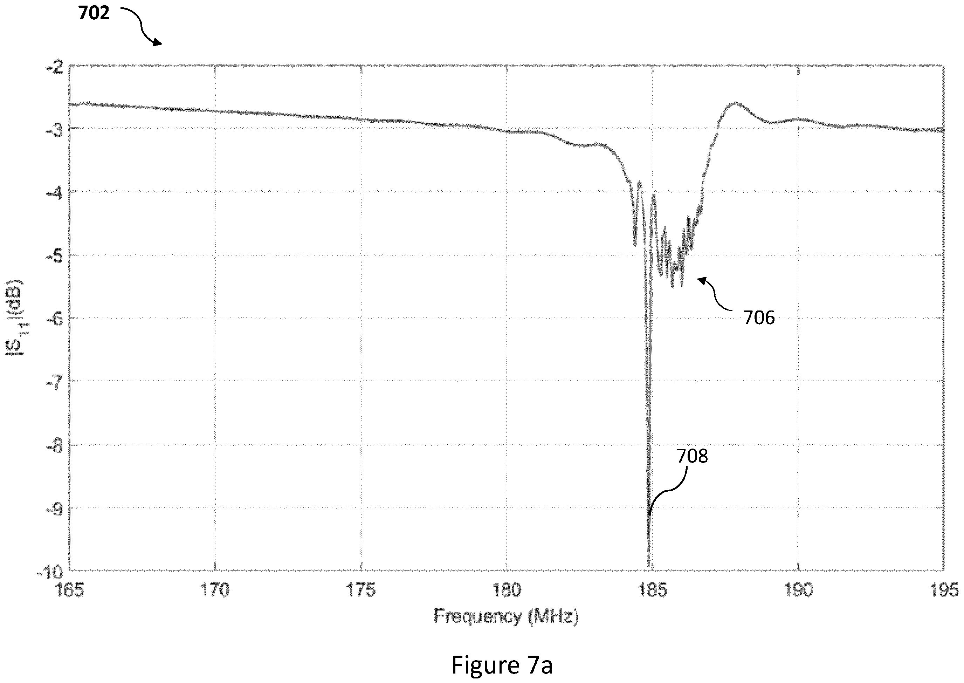

Figure 7a is a graph 702 showing test data for the first example 602 of the SAW sensor element. The vertical axis of the graph 702 indicates the reflection coefficient S11 in units of dB, and the horizontal axis indicates frequency in units of MHz. In this example, a resonant frequency, indicated by a sharp dip in S11 value, of the first example 602 of the SAW sensor element is at about 185MHz.

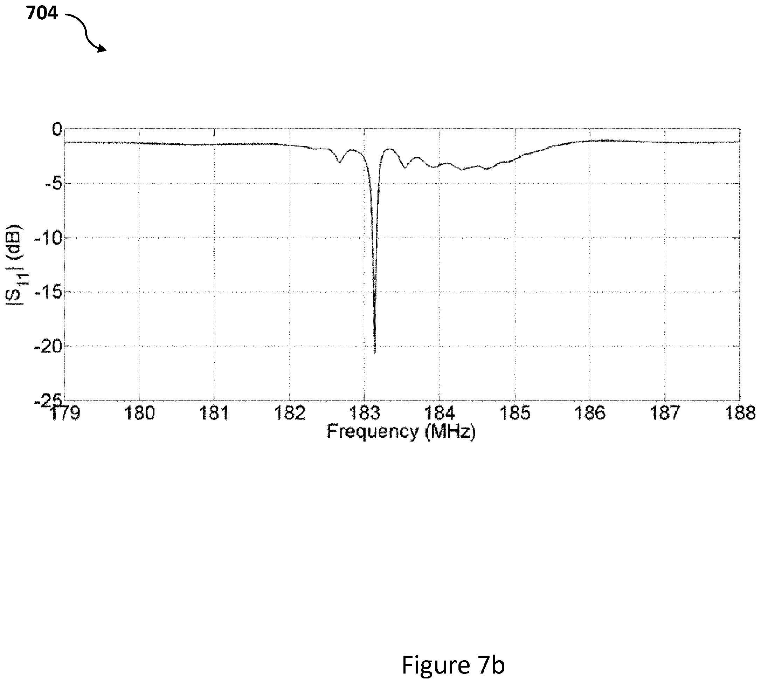

Figure 7b is a graph 704 showing test data for the second example 604 of the SAW sensor element. The axes of the graph are the same as in Figure 7a. In this example, the resonant frequency of the second example 604 of the SAW sensor element is at about 183.1MHz. The difference in the resonant frequency between the first example 602 of the SAW sensor element and the second example 604 of the SAW sensor element is believed to be due to the first example 602 of the SAW sensor element having the described cap layer and the second example 604 of the SAW sensor element not having the cap layer.

Furthermore, the second example 604 of the SAW sensor element has an electrode layer thickness of 180nm, whereas the first example 602 of the SAW sensor element has an electrode layer thickness of 130nm. It can be seen from Figure 7a that the data for the first example 602 shows side lobes 706 beside the main resonant frequency peak 708. However, side lobes beside the main resonant frequency peak 810 in the graph 704 for the second example 604 are reduced in comparison to the side lobes for the first example 602.

Accordingly, it is believed that IDTs with electrode layer thickness of 180nm provide a reduction in the side lobes beside the main resonant frequency peak compared to, for example, IDTs with an electrode layer thickness of 130nm. Reduced side lobes in the frequency response result in an easily identifiable resonant frequency. In other words, the resonant frequency of the second example 604 of the SAW sensor element is more clearly defined in the output signal, for example, as compared to the first example 602 of the SAW sensor element. For example, the resonant frequency can be extracted more easily in the case of the second example 604 of the SAW sensor element from the respective output signal.

It will be appreciated that various methods may be used to analyse the output signal in order to determine or extract the resonant frequency of the SAW sensor element in question from the output signal. For example, the controller 508 of the interrogation apparatus determines the resonant frequency from the output signal by analysing the output signal. Computational techniques such as data fitting, match filtering, etc. may be used to determine the resonant frequency from the output signal. Those skilled in the art will appreciate the various computational methods for extracting the desired data from a signal.

Given a more well-defined resonant frequency in the output signal, the controller 508 may determine the resonant frequency more accurately and/or precisely, as compared to a less well-defined resonant frequency in the output signal, even at lower signal power levels and/or with lower overall signal to noise ratios. A more well-defined resonant frequency in the output signal of the second example 604 of the SAW sensor element (due to the electrode thickness being 180nm) may result in the controller 508 determining the resonant frequency more accurately and/or precisely in the case of the second example 604 of the SAW sensor element compared to the first example 602 of the SAW sensor element.

For example, the controller 508 determines the temperature of the SAW sensor element in question from the resonant frequency determined from the output signal. The determined temperature of the SAW sensor element may be taken to be the temperature of the brake disc in question. In some examples, an offset may be added to the temperature of the SAW sensor element to determine the temperature of the brake disc to which it is attached (or some other mathematical transformation may be used).

Therefore, a more accurate and/or precise determination of the resonant frequency of the SAW sensor element may lead to a more accurate and/or precise determination of the temperature of the brake disc. The electrode thickness of the IDTs in the SAW sensor element being 180nm therefore provides for a more accurate and/or precise determination of temperature compared to other electrode thicknesses, for example, 130nm.

In some examples, there is provided a SAW sensor element comprising one or more IDTs with an electrode thickness between 120nm and 190nm, where the SAW sensor element has a resonant frequency of 188 MHz at a temperature of 24°C. In some such examples, there is provided a SAW sensor element comprising one or more IDTs with an electrode thickness of 180nm, where the SAW sensor element has a resonant frequency of 188 MHz at a temperature of 24°C.

In some examples, there is provided a brake disc for an aircraft wheel brake comprising the temperature sensing device according to any of the described examples. In some examples, there is provided an aircraft comprising such a brake disc.

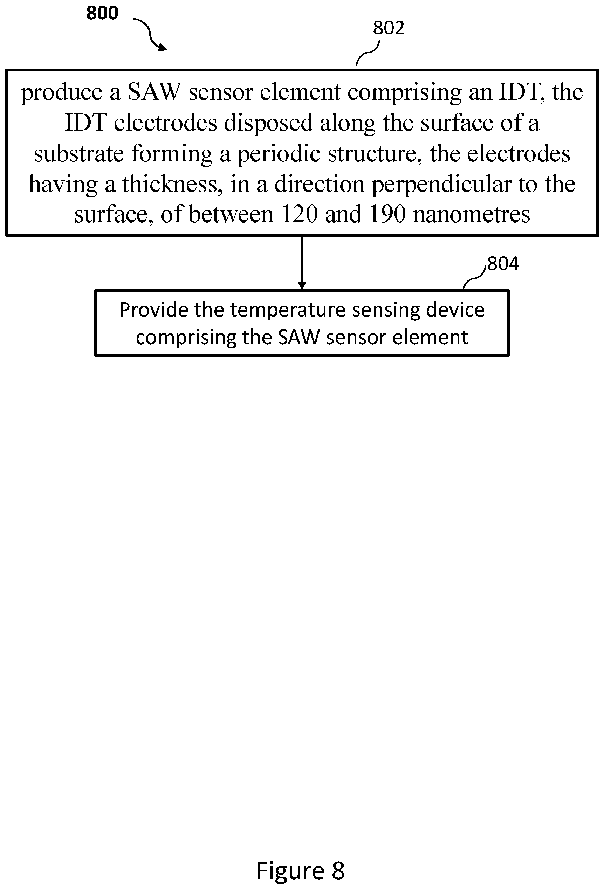

Figure 8 is a flow diagram illustrating a method 800 of manufacturing a temperature sensing device (such as the described temperature sensing device 300) for sensing aircraft wheel brake temperature. At block 802 of the method 800, a SAW sensor element comprising an IDT with an electrode thickness between 120nm and 190nm is produced. The IDT comprises electrodes disposed along the surface of a substrate forming a periodic structure. The thickness of the electrodes is in a direction perpendicular to the surface. As previously described, the direction referred to is into the page with respect to Figure 4 and perpendicular to the surface 408.

Those skilled in the art will appreciate the methods which can be used to produce a SAW sensor element such as the described SAW sensor element 302 according to block 802.

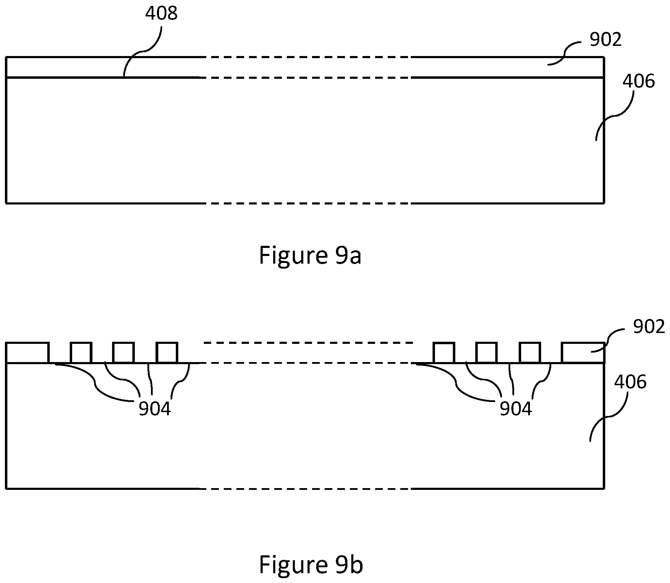

Figures 9a-d are simplified schematic side-cross sectional views of an example SAW sensor element 302 at different stages of production. In Figures 9a-d, the centre portions of the examples of the SAW sensor element 302 at different stages of production are indicated using dashed lines to indicate that portions in the centre are not shown. For example, the starting point may be a piezoelectric substrate (for example, as previously described) of an appropriate size for the SAW sensor element 302. A photoresist coating may be deposited on the top surface 408 of the piezoelectric substrate 406.

Figure 9a is a simplified schematic side cross-sectional view of the piezoelectric substrate 406 with a photoresist coating 902 deposited on the top surface of the piezoelectric substrate 406.

For example, lithographic techniques may be used in order to remove portions of the photoresist coating 902 to leave exposed portions of the top surface 408 of the piezoelectric substrate 406 where material for electrodes is to be deposited. Figure 9b is a schematic side-cross sectional view of a stage at which portions of the photoresist coating 902 have been removed. At the stage shown in Figure 9b, there are provided exposed portions 904 of the top surface of the piezoelectric substrate 406.

For example, material for the electrodes may be deposited on the exposed portions 904 to form the electrodes of the IDTs of the SAW sensor element 302 being produced. The material for the electrodes is an electrically conductive material.

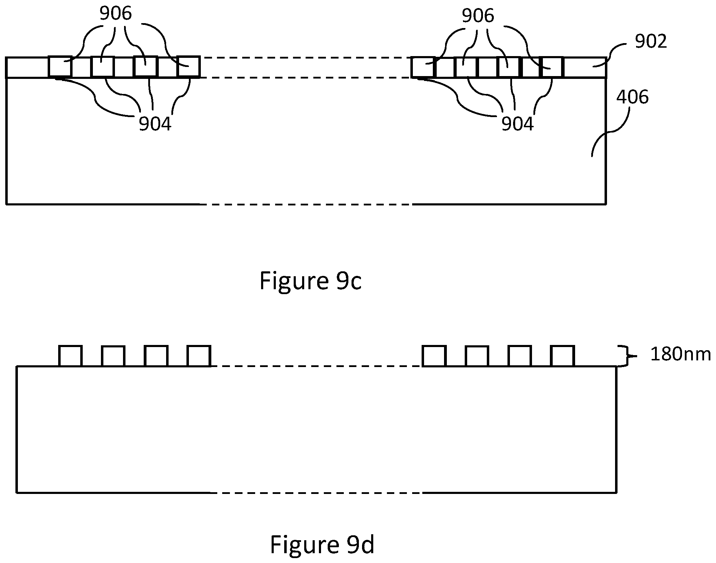

Figure 9c is a schematic side-cross sectional view of a stage at which material for the electrodes 906 has been deposited on the exposed portions 904 of the top surface of the piezoelectric substrate 406. Electrode material 906 is deposited such that the layers of deposited electrode material 906 have a desired thickness, according to the desired thickness of the electrodes of the IDTs.

In the example of Figure 9c, electrode material 906 is deposited such that the layers of the deposited electrode material 906 have a thickness of substantially 180nm. Subsequently to the deposition of the electrode material 906, the remaining photoresist coating 902 may be removed.

Figure 9d is a schematic side-cross sectional view of a stage after removal of the remaining photoresist coating 902 to leave behind the deposited electrode material 906 on the top surface of the piezoelectric substrate 406.

Further processes may be performed as part of the production of the SAW sensor element 302. For example, a cap layer may be deposited to cover the electrode material 906 and top surface of the piezoelectric substrate 406.

At block 804 of the method 800, the temperature sensing device (e.g., the temperature sensing device 300) comprising the SAW sensor element 302 is provided. For example, the SAW sensor element 302 produced at block 802 is installed in a housing of the temperature sensing device 300 and electrically coupled to the sensor antenna 304 of the temperature sensing device 300.

Certain components are described as being electrically coupled to other components. In some examples, components may be electrically coupled by virtue of an electrical connection. Those skilled in the art will appreciate that electronic components may also be capacitively or inductively coupled, for example. The type of electrical coupling depends on the characteristics of the electronic components and the particular application.

It should be noted that the Figures show simplified schematic views for the purpose of illustration. The Figures are intended to illustrate the described concepts and are not intended to convey dimensions, relative sizes of components and the like. In some cases, certain components are not shown for simplicity, as will be appreciated by those skilled in the art.

Although the invention has been described above with reference to one or more preferred examples, it will be appreciated that various changes or modifications may be made without departing from the scope of the invention as defined in the appended claims.

## Claims

1. A temperature sensing device for sensing aircraft wheel brake temperature, the temperature sensing device comprising:

a surface acoustic wave, SAW, sensor element comprising an interdigital transducer, the interdigital transducer comprising electrodes disposed along the surface of a substrate forming a periodic structure, the electrodes having a thickness, in a direction perpendicular to the surface, of between 120 and 190 nanometres.

2. The temperature sensing device according to claim 1, wherein:
the electrode thickness is substantially 180 nanometres.

3. The temperature sensing device according to claim 1 or claim 2, wherein:
the SAW sensor element has a resonant frequency of 188 megahertz at a temperature of 24°C.

4. The temperature sensing device according to any one of the preceding claims, wherein:

the SAW sensor element comprises an input interdigital transducer and an output interdigital transducer; and
the electrode thickness of both the input interdigital electrode and the output interdigital electrode is substantially the same.

5. A brake disc for an aircraft wheel brake comprising the temperature sensing device according to any one of claims 1 to 4 attached to the brake disc.

6. An aircraft comprising the brake disc according to claim 5.

7. A method of manufacturing a temperature sensing device for sensing aircraft wheel brake temperature, the method comprising:

producing a surface acoustic wave, SAW, sensor element comprising an interdigital transducer, the interdigital transducer comprising electrodes disposed along the surface of a substrate forming a periodic structure, the electrodes having a thickness, in a direction perpendicular to the surface, of between 120 and 190 nanometres; and
providing the temperature sensing device comprising the SAW sensor element.

8. The method according to claim 7, wherein:
the electrode thickness is 180 nanometres.

Figure 1

Figure 2

Figure 3

Figure 4

Figure 5

Figure 6a

Figure 6b

Figure 7a

Figure 7b

EP 4 186 792 A1

**800**

802

produce a SAW sensor element comprising an IDT, the IDT electrodes disposed along the surface of a substrate forming a periodic structure, the electrodes having a thickness, in a direction perpendicular to the surface, of between 120 and 190 nanometres

804

Provide the temperature sensing device comprising the SAW sensor element

Figure 8

Figure 9a

Figure 9b

906    906    902

904    904    406

Figure 9c

180nm

Figure 9d

| | Europäisches Patentamt European Patent Office Office européen des brevets | **EUROPEAN SEARCH REPORT** | Application Number EP 22 21 0154 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 3 255 399 A2 (AIRBUS OPERATIONS LTD [GB]; AIRBUS OPÉRATIONS SAS [FR]) 13 December 2017 (2017-12-13) * paragraphs [0001], [0004], [0005], [0008], [0015], [0019], [0030], [0036]; claims 8,11; figures 4,12 * ----- | 1-8 | INV. B64C25/42 F16D55/00 G01K13/08 G01K11/26 F16D66/00 |
| A | Zhgoon Sergei A. ET AL: "High Temperature SAW Resonator Sensors: Electrode Design Specifics", , 31 December 2017 (2017-12-31), XP093030015, Retrieved from the Internet: URL:https://hal.univ-lorraine.fr/hal-01868419/document [retrieved on 2023-03-08] * the whole document * ----- | 1-8 | |
| Y | EP 2 980 550 A1 (CENTRE NAT RECH SCIENT [FR] ET AL.) 3 February 2016 (2016-02-03) * paragraphs [0001] – [0003], [0069] – [0085] * ----- | 1-8 | TECHNICAL FIELDS SEARCHED (IPC) B64C F16D G01K |
| Y | CN 106 338 347 A (UNIV TSINGHUA) 18 January 2017 (2017-01-18) * paragraphs [0001], [0006], [0009], [0011], [0012] * ----- | 1-8 | |
| Y | EP 2 933 619 A1 (CENTRE NAT RECH SCIENT [FR] ET AL.) 21 October 2015 (2015-10-21) * paragraphs [0001], [0002], [0009], [0044] * ----- | 1-8 | |

The present search report has been drawn up for all claims

| Place of search | Date of completion of the search | Examiner |
|---|---|---|
| The Hague | 9 March 2023 | Phleps, Stefanie |

## ANNEX TO THE EUROPEAN SEARCH REPORT
## ON EUROPEAN PATENT APPLICATION NO.

EP 22 21 0154

This annex lists the patent family members relating to the patent documents cited in the above-mentioned European search report.
The members are as contained in the European Patent Office EDP file on
The European Patent Office is in no way liable for these particulars which are merely given for the purpose of information.

09-03-2023

| Patent document cited in search report | | Publication date | Patent family member(s) | | Publication date |
|---|---|---|---|---|---|
| EP 3255399 | A2 | 13-12-2017 | EP | 3255399 A2 | 13-12-2017 |
| | | | EP | 3789744 A1 | 10-03-2021 |
| | | | GB | 2550364 A | 22-11-2017 |
| | | | US | 2017363482 A1 | 21-12-2017 |
| | | | US | 2020158580 A1 | 21-05-2020 |
| EP 2980550 | A1 | 03-02-2016 | EP | 2980550 A1 | 03-02-2016 |
| | | | US | 2016025577 A1 | 28-01-2016 |
| CN 106338347 | A | 18-01-2017 | NONE | | |
| EP 2933619 | A1 | 21-10-2015 | EP | 2933619 A1 | 21-10-2015 |
| | | | WO | 2015158912 A1 | 22-10-2015 |

EPO FORM P0459

For more details about this annex : see Official Journal of the European Patent Office, No. 12/82